(19)

Europäisches
Patentamt

European
Patent Office

Office européen
des brevets

(11) **EP 2 916 103 A1**

(12) **EUROPEAN PATENT APPLICATION**

(43) Date of publication:
**09.09.2015 Bulletin 2015/37**

(51) Int Cl.:
***G01B 11/06*** *(2006.01)*

(21) Application number: **15157520.6**

(22) Date of filing: **04.03.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **04.03.2014 EP 14157654**

(71) Applicant: **LayTec AG**
**10709 Berlin (DE)**

(72) Inventors:
• **Zettler, Joerg-Thomas**
**12587 Berlin (DE)**

• **Camus, Christian**
**10557 Berlin (DE)**
• **Groß, Claudine**
**12157 Berlin (DE)**
• **Buick, Benjamin**
**13353 Berlin (DE)**
• **Zettler, Johannes**
**10245 Berlin (DE)**

(74) Representative: **Gulde & Partner**
**Patent- und Rechtsanwaltskanzlei mbB**
**Wallstraße 58/59**
**10179 Berlin (DE)**

(54) **Method and appararus for real-time analysis of complex thin-film multi-layer growth processes**

(57)    A method for real-time analysis of complex thin-film multi-layer growth processes, the method comprising: repetitively irradiating a growing thin-film structure (8); measuring the reflectance $R_{exp,1}(t)$ values received from the growing thin-film structure (8) for a set of wavelength and for each deposited layer L; calculating the virtual back surface complex reflectance $r_{vbs}$ according to the virtual interface approximation (VIA) method; determining the growth rate $g_L$ of layer L and providing the obtained growth rate $g_L$ to an optical feed-back control system (1) for comparing the obtained growth rate $g_L$ with the expected growth rate and finally adjusting the growing parameters according to the difference between the obtained growth rate $g_L$ and the expected growth rate.

This method allows for quantitative optical in-situ analysis (spectroscopic or multi-wavelength) and related feed-back control of multi-layer thin-film growth under extreme conditions: growth performed on large area semiconductor substrates and at high growth rate, with a total number of layers in the stack reaching up to 100 layers or more.

Fig. 2

EP 2 916 103 A1

## Description

## BACKGROUND OF THE INVENTION

### 1. Field of the Invention

The present invention relates to a method and an apparatus for real-time analysis of complex thin-film multi-layer growth processes, which allows for the quantitative optical in-situ analysis (spectroscopic or multi-wavelength) and related feed-back control of multi-layer thin-film growth.

### 2. Description of Related Art

Monitoring the growth of thin-films during deposition is a very important tool for achieving the desired film thickness when growing multi-layer systems.

It is well known that for multi-layer analysis by in-situ reflectance the so-called virtual interface approximation (VIA) can be applied for dielectric or semiconducting layers grown by PECVD, PVD or related deposition methods. However, in real applications with very thin layers and high number of films phase-mixing effects occur, which affect the accuracy of VIA based simulations as compared to real measured data.

According to a method of the prior art an optical feed-back control (OFBC) can be employed for monitoring the film growth as described in the following. Before starting the thin-film growing process, the OFBC system is loaded with the necessary information (or "growth recipe") of the target thin-film structure - i.e. desired target thickness for each layer, expected growth rates, material of substrate and material of each layer, total number of layers, etc. - typically through network communication from the growth system to the OFBC system. The OFBC system uses a number $i$ of reflection wavelengths $\lambda_i$ each having a non-zero bandwidth (typically around 5nm). Throughout the growing process, which starts with the bare substrate and ends after the final layer of the stack, the OFPC system measures the normal incidence reflectance at a set of wavelengths, e.g., between 2 and 2048 wavelength in the UV-NIR spectral range each having a typical spectral bandwidth between 2nm and 5nm. The data acquisition rate has to be high for precisely resolving at all wavelengths the oscillating reflectance signatures (Fabry-Perot oscillations, FPOs) which are rapidly changing with the changing thickness of the fast growing top layer. During the growing process the OFPC system continuously compares the measured set of reflectance values $R^i_{exp}(t, \lambda_i)$ with modeled reflectance values $R'_{mod}(t, \lambda_i)$. The index $i$ refers to the respective specific wavelength of the multi-wavelength OFBC system. The modeled growth rate values are determined by applying well-known multi-layer thin-film optics and adjusting in the model the growth rate of the just growing film for best fitting to the measured reflectance data.

The real-time modeling process and the thin-film growth process are synchronized by auxiliary signals sent by the growth system to the in-situ metrology system, in order to synchronize the data analysis to the start and stop of the growth of each layer of the stack. The in-situ metrology system in feed-back control mode typically determines the growth rate of the growing top layer within the first 80% of the expected growth time. In order to regulate the growing process, the OFBC system compares the measured growth rate $g_{exp}$ with the expected growth rate $g_{recipe}$ according to the growth recipe. In case the difference $(g_{exp}-g_{recipe})$ between the measured growth rate and the expected growth rate exceeds a predetermined threshold, then the OFBC system sends an updated growth time $t_{OFBC}= t_{recipe}{}^{*}(g_{recipe}/g_{exp})$ to the growth system, that replaces the expected growth time $t_{recipe}$. Accordingly, the growth system stops the growing of the layer after $t_{OFBC}$ instead of $t_{recipe}$ in order to reach the exact target thickness of the film. The OFBC system memorizes all thicknesses of all previously grown layers and adds them to the optical model as known parameters. This procedure goes on until the last layer of the stack has been grown.

The above described method works well for layer stacks wherein the overall thickness of transparent layers is not too high. That is, in case the total optical thickness of the layer stack $n_{ave}{}^{*}d_{total}$ given by the product of the average refractive index $n_{ave}$ and the total thickness $d_{total}$ reaches several multiples of the wavelength, the non-zero spectral band-width of the OFBC system causes phase mixing effects and the magnitude of measured reflectance signatures (Fabry-Perot-oscillations) starts shrinking, the fit quality deteriorates and the accuracy of growth rate measurement suffers.

A solution for this problem is to integrate the phase mixing effect into the optical model. This, however, is on the expense of significantly longer calculation times in the OFBC system. Furthermore, even if taking into account the optical phase-mixing, the method described so far works well only for multilayer systems up to 5-10 layers. For a higher number of layers in the stack the experimental errors mount up (cumulative errors and error propagation) and in consequence, the accuracy of the feed-back control algorithm decreases.

A solution to this problem of cumulative errors is known from D.E. Aspnes, Optical approaches to determine near-surface compositions during epitaxy, Journal of Vacuum Science & Technology, 1996, according to which the number of fitting parameters is reduced by applying so called virtual interface approximations (VIA). In this method, the optical effect of most of the already grown layers and of the substrate is translated into the magnitude and phase of reflectance of a 'virtual' interface located just behind the growing top layer. Changes of refractive indices (n,k) of the materials involved with temperature (both temporarily and permanent) have to be taken into account.

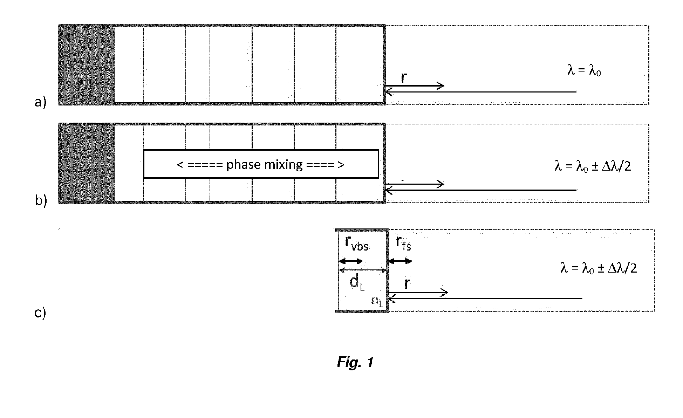

However, the methods of the prior art cannot be applied in cases where the two effects (spectral broadening and cumulative errors) are combined, i.e. when phase-mixing within the spectral bandwidth of the OFBC reflectance measurement system occurs and the virtual interface approximation is needed for avoiding error accumulation in the multi-layer analysis. The reason is that phase-mixing in reality occurs in the many buried, previously grown layers as shown in Fig. 1(b), but it disappears when applying the VIA optical model, because all the buried layers have to be replaced by a single virtual interface (virtual back surface) having a complex reflectance $r_{vbs}$ as shown in Fig.1(c). Hence, modeling of phase-mixing as described in the prior art is not feasible in a VIA model.

A simple solution to the phase-mixing/VIA problem would be to forcibly reduce the spectral bandwidth close to zero. This, however, is not realistic in many cases because multi-wavelength OFBC systems need a larger optical bandwidth for getting sufficiently high photon flux density through the small viewport. These high photon flux densities are necessary for achieving both extremely low noise reflectance measurements and very high data acquisition rates.

### 3. Summary of the invention

It is therefore an object of the present invention to provide a method and an apparatus for real-time analysis of complex thin-film multi-layer growth processes which overcomes the disadvantages of the prior art.

In particular, it is an object of the present invention to provide a method and an apparatus for real-time analysis of complex thin-film multi-layer growth processes which allows for the quantitative optical in-situ analysis (spectroscopic or multi-wavelength) and related feedback control of multi-layer thin-film growth under extreme conditions: growth performed on large area semiconductor substrates and at high growth rate, with a total number of layers in the stack reaching up to 100 layers or more.

According to a first aspect of the present invention, a method for real-time analysis of complex thin-film multi-layer growth processes is provided, which is suitable for depositing structures consisting of N layers, wherein $N$ is the total number of layers deposited on a substrate, and taking place in a thin-film growth system comprising a reactor housing having a view-port opening. The method comprises the following steps: repetitively irradiating a growing thin-film structure, the growing thin-film structure comprising a substrate on which a plurality of layers is subsequently deposited, during the entire growing process; measuring the reflectance received from the growing thin-film structure during deposition of a first layer for a set of wavelength values; determining the growth rate of the first layer from the measured reflectance according to the virtual interface approximation method; measuring the reflectance received from the growing thin-film structure during deposition of each subsequent layer $L$, with $L$ ranging from 2 through $N$, for a set of wavelength values; for each layer $L$, with $L$ ranging from 2 through $N$, calculating the virtual back surface complex reflectance according to the virtual interface approximation method; for each layer $L$, with $L$ ranging from 2 through $N$, calculating the variation of the virtual back surface complex reflectance $\Delta r_{vbs}$ for a plurality of wavelength values within the range between $\lambda_0 \Delta\lambda/2$ and $\lambda_0 + \Delta\lambda/2$, wherein $\lambda_0$ is the central wavelength of the light irradiated onto the growing thin-film structure; calculating the real time reflectance transient for the wavelength $\lambda_0$ by averaging the measured real time reflectance transient over the wavelength range between $\lambda_0 - \Delta\lambda/2$ and $\lambda_0 + \Delta\lambda/2$; determining the growth rate of layer $L$ by fitting the obtained real time reflectance transient $R_{exp, L}(t, \lambda_0) = |r|^2$, $r$ being the complex reflectance; providing the obtained growth rate to an optical feed-back control system; comparing the obtained growth rate with the expected growth rate and adjusting the growing parameters according to the difference between the obtained growth rate and the expected growth rate.

Preferably, the growing thin-film structure is irradiated at a normal incident angle. Alternatively, the growing thin-film structure may also be irradiated at non-normal incidence; in this case the reflectance has to be calculated separately for the perpendicular and parallel polarization component.

Preferably, when determining the growth rate $g_L$ of layer $L$ by fitting the obtained real time reflectance transient $R_{exp, L}(t, \lambda_0) = |r|^2$ the complex reflectance is fitted according to the equation:

$$r = \frac{r_{fs} + r_{vbs}e^{-2i\beta}}{1 - r_{fs}\, r_{vbs}e^{-2i\beta}} \qquad (1),$$

wherein $r_{fs}$ is the complex reflectance of the top surface the phase parameter $\beta$ is defined as $\beta = 2\pi * n_L d_L / \lambda_0$, $d_L = g_L * t$ being the film thickness of layer $L$ and $n_L$ being the refractive index of layer $L$. Preferably, the fitting is done using the three fitting parameters $g_L$, $Re(r_{vbs})$, $Im(r_{vbs})$.

According to a further aspect of the present invention, an apparatus for real-time analysis of complex thin-film multi-layer growth is provided, which is suitable for processes taking place in a thin-film growth system comprising a reactor housing having a view-port opening, the apparatus comprising: an optical head adapted to irradiate a growing thin-film structure accommodated in the reactor housing through the view-port opening and to receive the reflected light reflected by the growing thin-film structure; an optical feed-back control system adapted to receive reflectance data from the optical head; a growth control system for controlling the process parameters of the thin-film growth system, the growth control system being adapted to supply la set [CC1] of said process parameters and synchronization signals to the optical feed-back control system and to receive a real-time feedback control signal from the optical feed-back control system; and a database for storing optical parameters of the thin-film materials used and adapted to provide said parameters to the optical feed-back control system.

Preferably, the optical head is adapted to irradiate the growing thin-film structure at a perpendicular angle. Alternatively, the optical head may be adapted to irradiate the growing thin-film structure under a certain incident angle and to detect the reflected light under the identical exit angle on the opposite side of the reactor apparatus.

Preferably, the optical feed-back control system is further adapted to determine a growth rate $g_L$ of the layer $L$ while it is grown on the growing thin-film structure according to the PM-VIA method as disclosed above.

## 4. Brief description of the drawings

The accompanying drawings, together with the specification, illustrate exemplary embodiments of the present invention, and, together with the description, serve to explain the principles of the present invention.

FIG. 1 shows a schematic sketch of three different conventional models for determining the reflectance of a multilayer stack; a) shows the straight forward calculation of the complex reflectance r in an ideal multilayer configuration with accurate wavelength $\lambda$; b) shows the case of a non-monochromatic measurement with a certain bandwidth $\Delta\lambda$, wherein the reflectance signatures are broadened mostly due to phase-mixing effects in the stack; c) shows data reduction by virtual interface approximation reducing the underlying layers to a single virtual interface;

FIG. 2 shows a block diagram illustrating an Optical Feed-Back Control system according to the present invention;

FIG. 3 shows a flowchart of the method for fast simulation of in-situ optical reflection data with phase-mixing effects, according to the present invention; and

FIG. 4 shows a diagram representing the variation of the complex reflectance of the virtual back surface as a function of the wavelength variation within the bandwidth around the central wavelength $\lambda_0$.

## 5. Detailed description of the invention

In the following detailed description, only certain exemplary embodiments of the present invention are shown and described, by way of illustration. As those skilled in the art would recognize, the invention may be embodied in many different forms and should not be construed as being limited to the embodiments set forth herein.

According to the present invention a method and an apparatus for the quantitative optical in-situ analysis and related feed-back control of multi-layer thin-film growth have been developed, which are capable to provide fast and accurate monitoring even under the following extreme conditions. On one hand, the method and apparatus can be used when growth is performed on large area semiconductor substrates even in showerhead reactors with highest uniformity requirements, i.e. only very tiny optical viewports with diameters similar to the gas-supplying openings (around 1 mm) in the showerhead are applicable for not reducing the uniformity of the growth. On the other hand, when multi-layer thin-film stacks are grown at high growth rate (up to 10nm/s) and consist of up to 100 or even more transparent or weakly absorbing layers (i.e. dielectric or semiconducting layers) with single-layer thicknesses between 5nm and 100nm.

The methods disclosed in the prior art cannot be applied under the above mentioned conditions because the discrepancy between the model and the experimental data mounts up with the numbers of layer so that the conventional models cannot deliver accurate results.

First, a brief introduction to the virtual interface approximation (VIA) will be given.

Fig. 1(a) shows a conventional model (e.g. like the method described in "Principles of oprtics" by Max Born and Emil Wolf) for determining the reflectance $R$ of a multilayer stack. According to this model the reflectance $R = |r|^2 = R(\lambda_0)$ is calculated using a well-known thin-film optical formula for a single wavelength, i.e. an assumption of ideal measurement at wavelength $\lambda_0$ with a zero spectral bandwidth is made. However, this approximation does not hold for reactors with very small optical viewports, e.g. with diameters around 1 mm, because a larger optical bandwidth must be applied, in order to reach a sufficiently high photon flux density in certain applications where narrow bandwidth lasers are not appropriate.

Furthermore, for a layer stack consisting of many layers, the number of fitting parameters increases very fast. For instance, in the exemplary embodiment of Fig. 1(a) the layer stack comprises an absorbing substrate and seven layers. For a given wavelength, each layer is characterized by three parameters: its refractive index $n$, its extinction coefficient $k$ (respectively corresponding to the real and imaginary part of the complex reflectance) and its thickness $d$. Hence, with $n_s$ and $k_s$ being the two optical constants of the substrate, the complex reflectance $r$ of this stack depends on a total of 2+(3*7)=23 parameters. The measured reflectance $R$ is given by the square of the absolute value of the resulting complex reflectance $r$.

For fast real-time analysis of the growth rate of the top layer, it is of advantage to reduce the number of independent parameters to a minimum: $n_L$ and $k_L$ being the known optical parameters of the top layer. Hence, assigning the refractive index of the ambient gas to be equal to 1, the complex reflectance of the top surface $r_{fs}$ is also known from Fresnel's equation. All other remaining 20 parameters of the underlying layers and substrate can be replaced by only two parameters: real and imaginary part of the complex reflectance $r_{vbs}$ of the virtual back surface of the top layer. Consequently, the thickness of the top layer $d_L$ is the only parameter changing during growth of the top layer. Therefore, the growth rate $g_L$ can be seen in theory as the only "real" fitting parameter in the 1-layer thin-film equation to be applied:

$$R_L(d_L) = |r|^2 \; ;$$

wherein

$$r = \frac{r_{fs} + r_{vbs}e^{-2i\beta}}{1 - r_{fs} r_{vbs}e^{-2i\beta}} \qquad (1),$$

wherein $\beta$ is a phase parameter defined as $\beta = 2\pi * n_L d_L / \lambda_0$, $\lambda_0$ is the central wavelength and the film thickness $d_L$ changes with growth time t according to $g_L * t$.

For practical reasons of error minimization, the two parameters of the virtual interface complex reflectance $r_{vbs}$ are usually fitted as additional auxiliary fit parameters. Hence, VIA is typically used as part of a three-parameter fit, wherein $g_L$ is the only fit parameter of importance.

This is shown in Fig. 1 (c), which depicts a model for determining the reflectance R of a multilayer stack, which is based on the virtual interface approximation (VIA) and is used for a measuring system having a wavelength bandwidth $\Delta\lambda$ around a center wavelength $\lambda_0$. According to this model the reflectance $R = <R>(\lambda_0, \Delta\lambda)$ is calculated from a weighted superposition of an equally distributed set of wavelengths between $[\lambda_0 - \Delta\lambda/2]$ and $[\lambda_0 + \Delta\lambda/2]$.

According to the VIA model the reflectance R is calculated in a simplifying virtual interface approximation for reduction of numerical fitting errors in real-time analysis. The weighted superposition of all wavelengths between $\lambda_0 - \Delta\lambda/2$ and $\lambda_0 + \Delta\lambda/2$ can be performed only in the remaining top-layer. Hence, the phase-mixing occurring in all other layers between substrate and top layer cannot be included and consequently the modeled reflectance R can be very different from the measured reflectance $<R>(\lambda_0, \Delta\lambda)$.

As has been explained, the simplification from full stack calculation of Fig. 1(a) to the VIA calculation of Fig.1 (c) has the advantage of reducing the number of parameters and thus shortening the time required for numerical calculation, but it cannot take into account the phase-mixing effect that affects the real measurement as shown in Fig. 1(b).

Therefore, an approximation was introduced, which well resembles the experimental data and which will be described in the following:

Firstly, for each layer L, with L ranging from 2 to N, N being the total number of layers in the final stack, and after completing growth of layers (L-1) the complex virtual interface reflectance $r_{vbs}$ for the wavelength $\lambda_0$ is calculated from the formerly determined film thicknesses of layers 1 through (L-1) and from the refractive index of the currently grown layer number L.

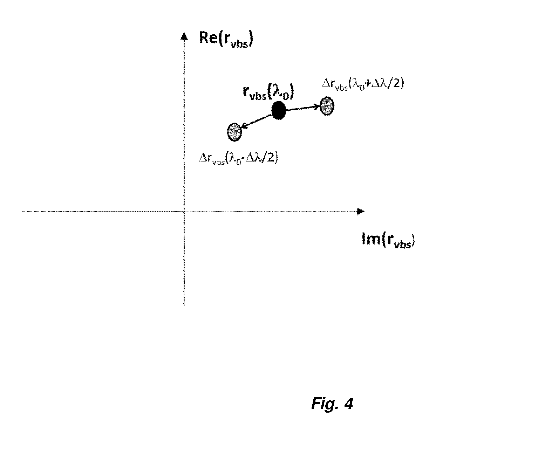

The described procedure is then repeated for a number of wavelengths in the range between $[\lambda_0 - \Delta\lambda/2]$ and $[\lambda_0 + \Delta\lambda/2]$. This provides the typical variation of $r_{vbs}$ in the complex plane due to phase-mixing, which is indicated as phase-mixing (PM) complex plane segment and is shown in Fig. 4.

Finally, in order to obtain an appropriate fit of the measured reflectance in the virtual interface approximation, one has to average - with proper weights depending on the spectral distribution of light intensities within the bandwidth range - over the several solutions of Eq. (1) while varying $r_{vbs}$ within the PM complex plane segment and with the phase factor $\beta$ of the top-most layer synchronously varying according to its definition.

Once a phase-mixing compatible virtual interface modeling is established, the following procedure for a high-speed fitting algorithm can be applied, according to which the real time reflectance transient for a given wavelength $\lambda_0$ is given by:

$$R_L(t) = <R_L(d_L = g_L * t)> \qquad (2);$$

wherein the operator $<>$ represents the averaging across the PM complex plane segment surrounding $r_{vbs}$ and $R_L$ is calculated according to equation (1) within the range of wavelengths between $[\lambda_0 - \Delta\lambda/2]$ and $[\lambda_0 + \Delta\lambda/2]$. The growth rate $g_L$ of layer $L$ is determined by fitting the modeled $R_L(t)$ to the measured $R_L^{exp}(t)$ with the only three fitting parameters growth rate $g_L$, $Re[r_{vbs}(\lambda_0)]$ and $Im[r_{vbs}(\lambda_0)]$.

The speed of convergence of this fitting procedure directly depends on the accuracy of the starting values for $g_L$, $Re[r_{vbs}(\lambda_0)]$ and $Im[r_{vbs}(\lambda_0)]$, and the above described feed-forward method is of great importance for guessing good starting values for $r_{vbs}$. Accordingly, at a certain stage of growth (e.g., after completed growth of (L-1) layers) the complex virtual interface reflectance $r_{vbs}$ for the wavelength $\lambda_0$ is calculated from the formerly determined film thicknesses of layers 1 through (L-1) and from the refractive index of the currently grown layer number L)

In order to further improve the accuracy of the method for periodical layer structures-such as stacks with a ABAB... layer structure - the phase-mixing VIA method can be expanded to up to three or four layers (using the third or fourth internal interface as virtual back surface). This brings a double advantage: a) even for very thin layers a three (or four) layer sequence usually includes a full Fabry-Perot oscillation (FPO), thereby improving fitting accuracy and b) because in an ABAB growth sequence only two growth rates (for material A and material B) have to be assumed, the ratio between number of measured data points to number of fit parameters further improves.

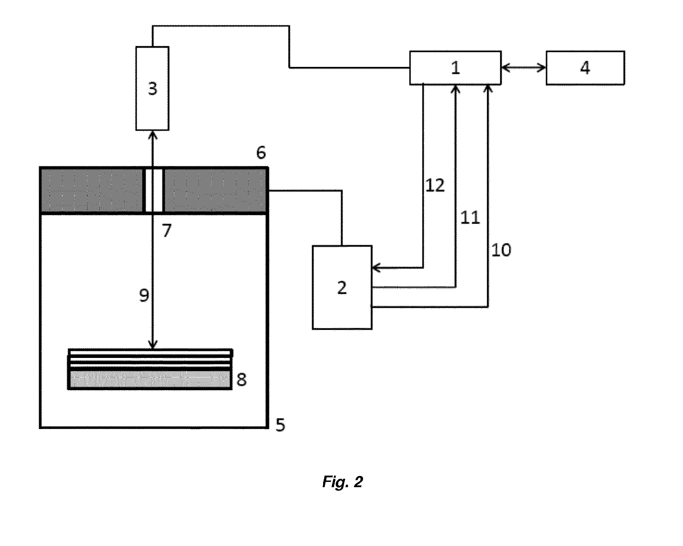

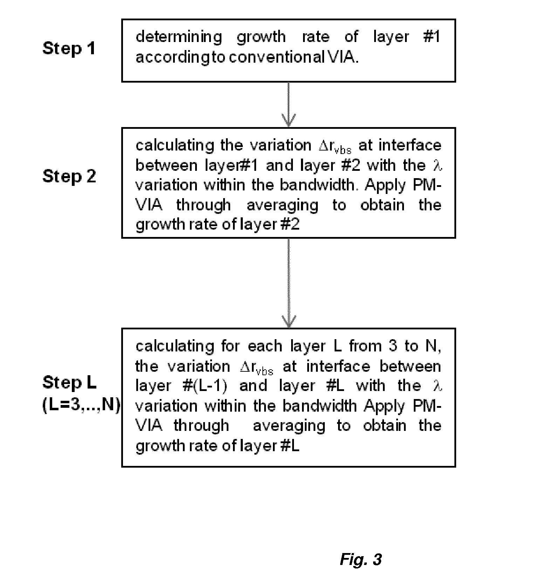

The method and apparatus described in the block diagram of Fig. 2 and in the flowchart of Fig. 3 provide a solution to the phase-mixing/VIA problem, which further includes very fast numerical algorithms for feed-back control of fast growing and complex multi-layer systems.

Fig. 2 shows a block diagram of an apparatus including an Optical Feed-Back Control (OFBC) system 1 and its integration into a thin-film growth system 5 with very small viewports. A growing thin-film structure 8 comprising the substrate and the multilayer stack is irradiated by a light beam 9 emitted by an optical head 3 and travelling through a view-port opening 7 inside a showerhead or the reactor housing 6 of the reactor. The optical head 3 measures the normal incidence reflectance data and supplies them to the OFBC system 1. The OFBC system is communicating with a growth control system 2 through at least three data lines: a first data line 10 for receiving a copy of the growth recipe of the target thin-film structure, a second data line 11 for receiving synchronization signals with the process during the thin-film growth and a third data line 12 for sending back in real-time the feedback control signals regarding growth rate and film thickness. The OFBC system applies the algorithms according to the scheme described in Fig. 3 and uses a database 4 for the optical data n, k of the thin-film materials involved.

Fig. 3 shows a flowchart representing the algorithm used by the OFBC system 1. According to the present invention, in a first step the growth of the first deposited layer is determined according to the conventional VIA method. Subsequently, for each following layer L - with L ranging from 2 to N, N being the total number of layers in the stack - the variation of the complex reflectance of the virtual back surface $\Delta r_{vbs}$ at the interface between layer L and layer (L-1) is calculated within the bandwidth $[\lambda_0-\Delta\lambda/2]$ to $[\lambda_0+\Delta\lambda/2]$, wherein the thickness of layer (L-1) is known from the preceding step. Finally the PM-VIA approximation is applied by averaging the measured reflectance in the virtual interface approximation across the PM complex plane segment surrounding $r_{vbs}$ according to equation (2) and the growth rate $g_L$ of layer $L$ can be obtained.

Optionally, in a further embodiment as emissivity-corrected pyrometer, the optical head 3 may also account for T-induced refractive index changes.

Fig. 4 shows a representation of the phase-mixing arising in the buried, already grown layers due to the variation of wavelength within the bandwidth around the central wavelength $\lambda_0$ by a variation of the complex reflectance of the virtual back surface.

According to the present invention, a method and an apparatus for real-time analysis of complex thin-film multi-layer growth processes are provided, which are capable of accurate and fast simulation of in-situ optical reflection data with phase-mixing effects.

According to the present invention, the apparatus employs a method of phase-mixing virtual interface approximation (PM-VIA), thus achieving highly accurate and fast growth rate fits, which can be performed in real-time during growth of very complex multi-layer structures. Differently to the systems of the prior art, accurate growth rates can be determined even with very small optical access to the growth chamber, as it is necessary for highly uniform growth. Furthermore, due to the new PM-VIA-method it is possible to obtain highly accurate growth rate measurements with multi-wavelength reflectance.

According to the present method, in-situ optical reflectance monitoring and related optical feed-back control (OFBC) is applied for achieving thickness of every single layer with accuracy better than 0.3nm, which is the order of one atomic layer in a semiconductor crystal.

The above-disclosed subject matter is to be considered illustrative, and not restrictive, and the appended claims are intended to cover all such modifications, enhancements, and other embodiments, which fall within the scope of the invention. Thus, the scope is to be determined by the broadest permissible interpretation of the following claims and their equivalents, and shall not be restricted or limited by the foregoing detailed description

## Claims

1. Method for real-time analysis of complex thin-film multi-layer growth processes for depositing structures consisting of N layers, wherein N is the total number of layers deposited on a substrate, taking place in a thin-film growth system (5) comprising a reactor housing (6) having a view-port opening (7), , the method comprising the following steps:

   a) repetitively irradiating a growing thin-film structure (8), the growing thin-film structure (8) comprising a substrate on which a plurality of layers is subsequently deposited, during the entire growing process;
   b) measuring the reflectance $R_{exp,1}(t)$ received from the growing thin-film structure (8) during deposition of a first layer for a set of wavelength values;
   c) determining the growth rate $g_1$ of the first layer from the measured reflectance $R_{exp,1}(t)$ according to the virtual interface approximation (VIA) method;
   d) measuring the reflectance $R_{exp,L}(t)$ received from the growing thin-film structure (8) during deposition of each subsequent layer $L$, with $L$

ranging from 2 through $N$, for a set of wavelength values;

e) for each layer $L$, with $L$ ranging from 2 through $N$, calculating the virtual back surface complex reflectance $r_{vbs}$ according to the virtual interface approximation (VIA) method;

f) for each layer $L$, with $L$ ranging from 2 through $N$, calculating the variation of the virtual back surface complex reflectance $\Delta r_{vbs}$ for a plurality of wavelength values within the range between $\lambda_0 - \Delta\lambda/2$ and $\lambda_0 + \Delta\lambda/2$, wherein $\lambda_0$ is the central wavelength of the light irradiated onto the growing thin-film structure (8);

g) calculating the real time reflectance transient $R_{exp, L}(t, \lambda_0)$ for the wavelength $\lambda_0$ by averaging the measured $R_{exp, L}(t)$ over the wavelength range between $\lambda_0 - \Delta\lambda/2$ and $\lambda_0 + \Delta\lambda/2$;

h) determining the growth rate $g_L$ of layer $L$ by fitting the obtained real time reflectance transient $R_{exp, L}(t, \lambda_0) = |r|^2$, $r$ being the complex reflectance;

i) providing the obtained growth rate $g_L$ to an optical feed-back control system (1);

j) comparing the obtained growth rate $g_L$ with the expected growth rate and adjusting the growing parameters according to the difference between the obtained growth rate $g_L$ and the expected growth rate.

2. The method of claim 1, wherein the growing thin-film structure (8) is irradiated at a normal incident angle.

3. The method of claim 2, wherein in step h) the complex reflectance is fitted according to the equation:

$$r = \frac{r_{fs} + r_{vbs}e^{-2i\beta}}{1 - r_{fs}\,r_{vbs}e^{-2i\beta}} \quad (1),$$

wherein $r_{fs}$ is the complex reflectance of the top surface the phase parameter $\beta$ is defined as $\beta = 2\pi^* n_L d_L/\lambda_0$, $d_L = g_L^* t$ being the film thickness of layer $L$ and $n_L$ being the refractive index of layer $L$.

4. The method of claim 3, wherein the fitting in step h) is done using the three fitting parameters $g_L$, $Re(r_{vbs})$, $Im(r_{vbs})$.

5. Apparatus for real-time analysis of complex thin-film multi-layer growth processes taking place in a thin-film growth system (5) comprising a reactor housing (6) having a view-port opening (7), the apparatus comprising:

- an optical head (3) adapted to irradiate a growing thin-film structure (8) accommodated in the reactor housing (6) through the view-port opening (7) and to receive the reflected light (9) reflected by the growing thin-film structure (8);
- an optical feed-back control system (1) adapted to receive reflectance data from the optical head (3);
- a growth control system (2) for controlling the process parameters of the thin-film growth system (5), the growth control system (2) being adapted to supply a copy of said process parameters (10) and synchronization signals (11) to the optical feed-back control system (1) and to receive a real-time feed-back control signal (12) from the optical feed-back control system (1); and
- a database (4) for storing optical parameters of the thin-film materials used and adapted to provide said parameters to the optical feed-back control system (1).

6. The apparatus according to claim 5, wherein the optical head (3) is adapted to irradiate the growing thin-film structure (8) at a perpendicular angle.

7. The apparatus according to claim 5, wherein the optical head (3) is adapted to irradiate the growing thin-film structure (8) at a non-perpendicular angle.

8. The apparatus according to one of claims 5 and 6, wherein the optical feed-back control system (1) is further adapted to determine a growth rate $g_L$ of the layer L while it is grown on the growing thin-film structure (8) according to the PM-VIA method as disclosed in one of claims 1 through 4.

a)

b)

< ===== phase mixing ==== >

$\lambda = \lambda_0$

$\lambda = \lambda_0 \pm \Delta\lambda/2$

$r_{vbs}$   $r_{fs}$

$d_L$

$n_L$

r

$\lambda = \lambda_0 \pm \Delta\lambda/2$

c)

*Fig. 1*

*Fig. 2*

**Step 1** | determining growth rate of layer #1 according to conventional VIA.

**Step 2** | calculating the variation $\Delta r_{vbs}$ at interface between layer#1 and layer #2 with the $\lambda$ variation within the bandwidth. Apply PM-VIA through averaging to obtain the growth rate of layer #2

**Step L (L=3,...,N)** | calculating for each layer L from 3 to N, the variation $\Delta r_{vbs}$ at interface between layer #(L-1) and layer #L with the $\lambda$ variation within the bandwidth Apply PM-VIA through averaging to obtain the growth rate of layer #L

*Fig. 3*

*Fig. 4*

**EP 2 916 103 A1**

# EUROPEAN SEARCH REPORT

Application Number

EP 15 15 7520

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | RICHTER U ET AL: "In situ measurements of optical film parameters and plasma monitoring during reactive sputtering for advanced in-line process control", THIN SOLID FILMS, ELSEVIER-SEQUOIA S.A. LAUSANNE, CH, vol. 516, no. 14, 30 May 2008 (2008-05-30), pages 4541-4545, XP023180396, ISSN: 0040-6090, DOI: 10.1016/J.TSF.2007.05.094 [retrieved on 2008-05-30] * Sections "2.3 Reflectometer" and "Closed loop control"; figures 2,5,10 * | 5-8 | INV. G01B11/06 |
| A | WO 2008/102179 A1 (OPTICAL REFERENCE SYSTEMS LTD [GB]; IRVINE STUART [GB]; GRIFFITHS CARL) 28 August 2008 (2008-08-28) * page 2, line 3 - page 9, line 20; figures 1-4 * | 1,5 | |
| A,D | D. E. ASPNES: "Optical approaches to determine near-surface compositions during epitaxy", JOURNAL OF VACUUM SCIENCE & TECHNOLOGY A: VACUUM, SURFACES, AND FILMS, vol. 14, no. 3, 1 May 1996 (1996-05-01), page 960, XP055202687, ISSN: 0734-2101, DOI: 10.1116/1.580422 * the whole document * | 1 | TECHNICAL FIELDS SEARCHED (IPC) G01B G01N H01L |
| A | US 4 707 611 A (SOUTHWELL WILLIAM H [US]) 17 November 1987 (1987-11-17) * the whole document * | 1 | |

-/--

The present search report has been drawn up for all claims

| Place of search | Date of completion of the search | Examiner |
|---|---|---|
| Munich | 16 July 2015 | Götz, Andreas |

Europäisches
Patentamt

European
Patent Office

Office européen
des brevets

**EUROPEAN SEARCH REPORT**

Application Number

EP 15 15 7520

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ZETTLER J-T: "Characterization of epitaxial semiconductor growth by reflectance anisotropy spectroscopy and ellipsometry", PROGRESS IN CRYSTAL GROWTH AND CHARACTERIZATION OF MATERIALS, ELSEVIER PUBLISHING, BARKING, GB, vol. 35, no. 1, 1 January 1997 (1997-01-01), pages 27-98, XP004097241, ISSN: 0960-8974, DOI: 10.1016/S0960-8974(97)00024-7 * Sections "2.2 Multilayer structures and virtual substrate approach" and "5.3 Growth rate measurement" * | 1 | |

TECHNICAL FIELDS
SEARCHED (IPC)

The present search report has been drawn up for all claims

| Place of search | Date of completion of the search | Examiner |
|---|---|---|
| Munich | 16 July 2015 | Götz, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 15 15 7520

This annex lists the patent family members relating to the patent documents cited in the above-mentioned European search report.
The members are as contained in the European Patent Office EDP file on
The European Patent Office is in no way liable for these particulars which are merely given for the purpose of information.

16-07-2015

| Patent document cited in search report | Publication date | Patent family member(s) | | Publication date |
|---|---|---|---|---|
| WO 2008102179 A1 | 28-08-2008 | GB | 2449327 A | 19-11-2008 |
| | | WO | 2008102179 A1 | 28-08-2008 |
| US 4707611 A | 17-11-1987 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **D.E. ASPNES.** Optical approaches to determine near-surface compositions during epitaxy. *Journal of Vacuum Science & Technology,* 1996